# EUROPÄISCHE PATENTANMELDUNG

(11) **EP 2 466 323 A2**
(43) Veröffentlichungstag der Anmeldung: **20.06.2012**
(21) Anmeldenummer: 11184985.7
(22) Anmeldetag: 13.10.2011
(51) Int. Cl.: G01R 31/12

(54) **Verfahren zum Detektieren von Störlichtbogenereignissen durch einen Fehlerzähler und Vorrichtung**

(30) Priorität: 17.12.2010 DE 102010063419
(71) Anmelder: Siemens Aktiengesellschaft, 80333 München (DE)
(72) Erfinder: Hueber, Alexander, 84085 Niederleierndorf (DE); Martel, Jean-Mary, 93105 Tegernheim (DE)

(57) **Zusammenfassung**

Es sollen sporadisch auftretende Störlichtbögen erkannt werden. Dazu wird ein Integral über der Zeit gebildet, wenn die Stromstärke einen Stromstärkeschwellwert und eine Rauschleistung einen Leistungsschwellwert übersteigt. Falls das Integral einen vorgegebenen ersten Integrationsschwellwert (S3) überschreitet, wird entschieden, dass ein Störlichtbogenereignis vorliegt. Außerdem wird ein Zähler (Int2) dann inkrementiert, wenn das Integral (Int1) zunächst einen unter dem ersten Integrationsschwellwert (S3) liegenden zweiten Integrationsschwellwert (S4) überschreitet und anschließend einen unterhalb des zweiten Integrationsschwellwerts (S4) liegenden dritten Integrationsschwellwert unterschreitet. Wenn der Wert des Zählers (Int2) einen vorgegebenen Zählerschwellwert (S6) übersteigt, wird entschieden, dass ein anderes Störlichtbogenereignis vorliegt. Damit können insbesondere sporadisch auftretende Störlichtbögen erfasst werden.

## Beschreibung

Die vorliegende Erfindung betrifft ein Verfahren zum Detektieren von Störlichtbogenereignissen in einem Wechselspannungsnetz durch Erfassen einer aktuellen Rauschleistung in dem Wechselspannungsnetz und Erfassen einer Amplitude einer Stromstärke in dem Wechselspannungsnetz. In Abhängigkeit von der Zeit wird ein Integral erhöht, wenn die aktuelle Amplitude der Stromstärke einen vorbestimmten Stromstärkeschwellwert überschreitet und die aktuelle Rauschleistung einen Leistungsschwellwert übersteigt. Außerdem wird das Integral in Abhängigkeit von der Zeit reduziert, wenn die Amplitude den vorbestimmten Stromstärkeschwellwert nicht überschreitet und/oder die aktuelle Rauschleistung den Leistungsschwellwert nicht übersteigt. Es wird schließlich entschieden, dass der Störlichtbogen vorhanden ist/war, wenn das Integral einen vorgegebenen Integrationsschwellwert übersteigt. Bei einem Störlichtbogenereignis kann es sich um einen oder mehrere Störlichtbögen handeln. Die vorliegende Erfindung soll sich insbesondere auf Wechselspannungsnetze gemäß dem IEC-Standard (International Electrical Commitee) mit 230 V und 50 Hz beziehen.

Bei Installationssystemen, z. B. Haushaltsinstallationssystem, kann es zu Störlichtbögen kommen, wenn Leitungen beziehungsweise deren Isolationen defekt oder angeschlossene Geräte nicht mehr in Ordnung sind. Um den Stromkreis möglichst rasch zu unterbrechen, wenn ein Störlichtbogen auftritt, werden Schutzschalter in dem Installationssystem eingesetzt.

Schutzschalter gegen Störlichtbögen werden auch AFDD (Arc Fault Detection Device) genannt. Derartige Schutzschalter sind Schutzgeräte, die mithilfe von komplexen Algorithmen elektrische Signale beziehungsweise deren Stromkreise überwachen, um Störlichtbögen in den elektrischen Installationen detektieren zu können.

Algorithmen, die stabil brennende Störlichtbögen von so genannten störenden Verbrauchern, wie z. B. elektrische Motoren mit Bürsten, unterscheiden können, sind beispielsweise aus der Druckschrift US 5 729 145 A bekannt. Die dort beschriebene Technik stellt ein gattungsgemäßes Verfahren zum Detektieren von Störlichtbögen dar.

Die Problematik der Detektion von Störlichtbögen liegt darin, dass Lichtbogenfehler in den allerwenigsten Fällen so schnell wie Kurzschlüsse entstehen. Lichtbogenfehler, die z. B. in Reihe zum Verbraucher auftreten, benötigen zuerst eine ausreichende Verkohlung im Bereich des Fehlers, bevor sie stabil brennen. Während der Verkohlungsphase brennt der Störlichtbogen sporadisch für teilweise nur wenige Halbwellen und ist somit nur sehr schwierig von störenden Lasten zu unterscheiden. Aber bereits in dieser Verkohlungsphase können vom Leiter gelöste Kupferteilchen mit mehreren 1000 °C Materialien in der Umgebung entzünden und dadurch Brände hervorrufen.

Die Aufgabe der vorliegenden Erfindung besteht darin, auch sporadisch auftretende Störlichtbögen zuverlässiger erkennen zu können.

Erfindungsgemäß wird diese Aufgabe gelöst durch ein Verfahren zum Detektieren von Störlichtbogenereignissen in einem Wechselspannungsnetz durch
- Erfassen einer aktuellen Rauschleistung in dem Wechselspannungsnetz,
- Erfassen einer Amplitude einer Stromstärke in dem Wechselspannungsnetz,
- Erhöhen eines Integrals in Abhängigkeit von der Zeit, wenn die aktuelle Amplitude der Stromstärke einen vorbestimmten Stromstärkeschwellwert überschreitet und die aktuelle Rauschleistung einen Leistungsschwellwert übersteigt,
- Reduzieren des Integrals in Abhängigkeit von der Zeit, wenn die Amplitude den vorbestimmten Stromstärkeschwellwert nicht überschreitet und/oder die aktuelle Rauschleistung den Leistungsschwellwert nicht übersteigt, und
- Entscheiden, dass ein Störlichtbogenereignis vorliegt, wenn das Integral einen vorgegebenen ersten Integrationsschwellwert übersteigt, sowie
- Inkrementieren eines Zählers nur dann, wenn das Integral zunächst einen unter dem ersten Integrationsschwellwert liegenden zweiten Integrationsschwellwert überschreitet und anschließend einen unterhalb des zweiten Integrationsschwellwert liegenden dritten Integrationsschwellwert unterschreitet, und
- Entscheiden, dass ein anderes Störlichtbogenereignis vorliegt, wenn der Wert des Zählers einen vorgegebenen Zählerschwellwert übersteigt.

Darüber hinaus wird erfindungsgemäß bereitgestellt eine Vorrichtung zum Detektieren von Störlichtbogenereignissen in einem Wechselspannungsnetz mit
- einer Leistungsmesseinrichtung zum Erfassen einer aktuellen Rauschleistung in dem Wechselspannungsnetz,
- einer Strommesseinrichtung zum Erfassen einer Amplitude einer Stromstärke in dem Wechselspannungsnetz,
- einer Integrationseinrichtung zum Erhöhen eines Integrals in Abhängigkeit von der Zeit, wenn die aktuelle Amplitude der Stromstärke einen vorbestimmten Stromstärkeschwellwert überschreitet und die aktuelle Rauschleistung einen Leistungsschwellwert übersteigt, sowie zum Reduzieren des Integrals in Abhängigkeit von der Zeit, wenn die Amplitude den vorbestimmten Stromstärkeschwellwert nicht überschreitet und/oder die aktuelle Rauschleistung den Leistungsschwellwert nicht übersteigt, und
- einer Logikeinrichtung zum Entscheiden, dass ein Störlichtbogenereignis vorliegt, wenn das Integral einen vorgegebenen ersten Integrationsschwellwert übersteigt, sowie
- einer Zählereinrichtung zum Inkrementieren eines Zählerwerts nur dann, wenn das Integral zunächst einen unter dem ersten Integrationsschwellwert liegenden zweiten Integrationsschwellwert überschreitet und anschließend einen unterhalb des zweiten Integrationsschwellwert liegenden dritten Integrationsschwellwert unterschreitet, wobei
- mit der Logikeinrichtung entschieden wird, dass ein anderes Störlichtbogenereignis vorliegt, wenn der Wert des Zählers einen vorgegebenen Zählerschwellwert übersteigt.

In vorteilhafter Weise wird somit ein zweigleisiges Detektionsverfahren und eine entsprechende Vorrichtung zum Detektieren von Störlichtbögen bereitgestellt. In einer ersten Entscheidungsstrecke wird lediglich der Wert eines Integrals (im einfachsten Fall ein mit einem vorbestimmten Takt hochgezählter Zählwert) beobachtet, ob er einen bestimmten ersten Integrationsschwellwert übersteigt. In einer zweiten, davon unabhängigen Entscheidungsstrecke wird der Verlauf des Integrals insbesondere auch unterhalb des ersten Integrationsschwellwerts bewertet. Steigt das Integral zunächst über einen zweiten Integrationsschwellwert und sinkt anschließend unter einen dritten Integrationsschwellwert, so gilt das als Zeichen, dass ein kurzer, sporadischer Störlichtbogen vorhanden war, der zwar noch nicht zum Auslösen gemäß dem ersten Integrationsschwellwert ausreicht, aber eine Schädigung des Materials verursacht haben kann. Es wird dann ein entsprechender Zähler hochgezählt. Bei mehreren solchen Ereignissen wird dann ein Zählerschwellwert überschritten und es gelten einer oder mehrere Störlichtbögen als sicher detektiert, sodass mit dieser Information eine entsprechende Aktion in die Wege geleitet werden kann.

Vorzugsweise liegt der zweite Integrationsschwellwert in einem Bereich zwischen 30 % und 70 % des ersten Integrationsschwellwerts. Insbesondere ist es von Vorteil, wenn der zweite Integrationsschwellwert bei 50 % des ersten Integrationsschwellwerts liegt. Dabei ist es auch günstig, wenn der dritte Integrationsschwellwert unter 20 %, insbesondere bei 10 % des ersten Integrationsschwellwerts liegt. Derartig dimensionierte Schwellwerte führen zu einem zuverlässigen Algorithmus zum Erkennen von sporadischen Störlichtbögen.

Das Erhöhen und Reduzieren des Integrals kann mit unterschiedlichen Geschwindigkeiten erfolgen. Demnach kann der Tatsache Rechnung getragen werden, dass die Störlichtbögen in unterschiedlichen Zeitabständen auftreten oder dass sich das Material nach dem Auftreten eines Störlichtbogens in gewisser Weise (z. B. durch Absenken der Temperatur) erholt.

Darüber hinaus kann ein Signal in dem Wechselspannungsnetz hinsichtlich einer Störlast analysiert werden, und bei Detektieren einer derartigen Störlast kann das Integral auf einen vorgegebenen Wert, insbesondere Null gesetzt werden. Damit lässt sich vermeiden, dass versehentlich ein Störlichtbogen detektiert wird, wenn lediglich eine Störlast im Wechselspannungsnetz betrieben wird.

Wenn das Integral auf einen vorgegebenen Wert, insbesondere Null zurückgesetzt wird, sollte auch der Zähler dekrementiert werden. Damit lässt sich verhindern, dass auf der zweiten Detektionsschiene bzw. -stufe, die mit dem Zähler realisiert wird, ein Detektionsfehler generiert wird, wenn eine Störlast, aber kein Störlichtbogen erkannt wird.

Der Zähler wird vorzugsweise nach einem vorgegebenen Zeitintervall dekrementiert. Somit erfolgt ein Entscheiden für ein Störlichtbogenereignis (d.h. einen Störlichtbogen beziehungsweise mehrere Störlichtbögen) nur dann, wenn das Integral in kürzerer Zeit mehrmals den zweiten Integrationsschwellwert übersteigt und den dritten Integrationsschwellwert unterschreitet. Zu selten auftretende Störlichtbogen führen nicht zu einem Detektieren eines kritischen Störlichtbogenereignisses.

Das Zeitintervall für das Dekrementieren des Zählers kann von dem aktuellen Wert des Zählers abhängen. So lässt sich beispielsweise ein exponentielles Abklingen mit einfachen Mitteln simulieren.

Besonders vorteilhaft ist, wenn ein Schutzschalter mit dem erfindungsgemäßen Verfahren zum Detektieren eines Störlichtbogenereignisses betrieben wird. Im Falle der Detektion eines derartigen Störlichtbogenereignisses wird dann der Schutzschalter ausgelöst, oder es wird ein entsprechendes Warnsignal ausgegeben. Damit kann der Schutzschalter auch als Vorwarninstrument eingesetzt werden.

Die vorliegende Erfindung wird nun anhand der beigefügten Zeichnungen näher erläutert, in denen zeigen:
FIG 1 ein Diagramm eines Stromverlaufs, eines Verlaufs einer Rauschleistung und eines Integratorsignals und
FIG 2 ein Integratorsignal, ein Störlastdetektionssignal und ein Zählersignal.

Die nachfolgend näher geschilderten Ausführungsbeispiele stellen bevorzugte Ausführungsformen der vorliegenden Erfindung dar.

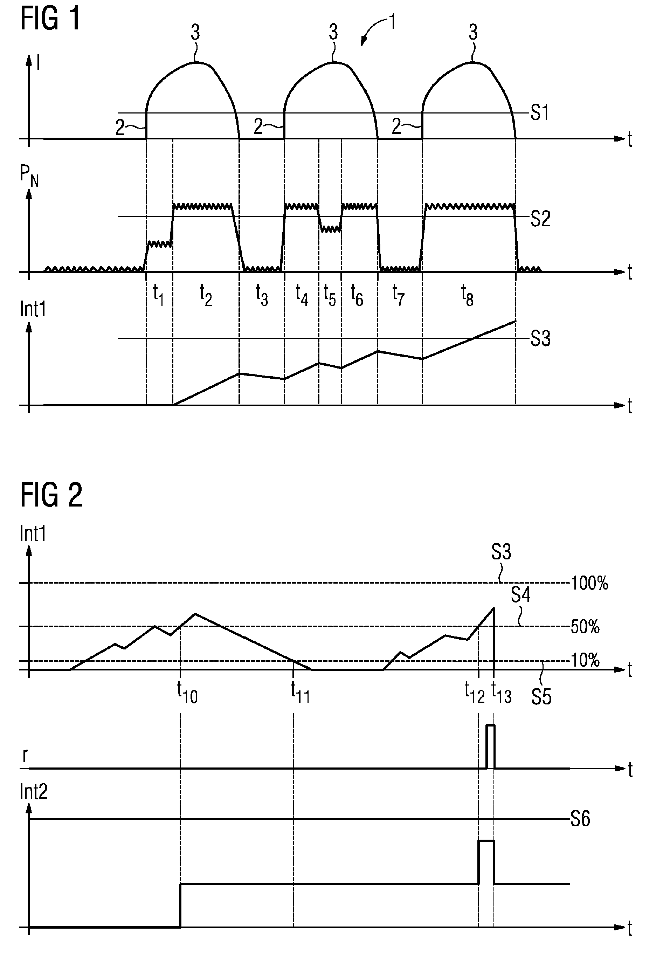

Die vorliegende Erfindung basiert auf der bekannten Technik, dass Störlichtbögen und insbesondere Reihenstörlichtbögen zuverlässig dadurch erkannt werden können, dass ein Integrator die Zeit aufintegriert, wenn die Stromstärke in einer Halbwelle einen bestimmten Wert überschreitet und gleichzeitig die Rauschleistung einen ebenfalls vorbestimmten Wert übersteigt. Entsprechend dem Beispiel von FIG 1 wird daher der Strom in dem Wechselspannungskreis untersucht. Hierzu wird der Strom beziehungsweise eine entsprechende Größe gleichgerichtet. Damit ergibt sich der in FIG 1 oben dargestellte Stromverlauf 1 über der Zeit t. Der Stromverlauf basiert auf dem sinusförmigen Wechselstrom und wird geprägt durch eine Flanke 2 zu Beginn jeder Halbwelle 3. Die steile Flanke ergibt sich beim Zünden eines Störlichtbogens bei jeder Halbwelle.

Übersteigt die Stromstärke während einer Halbwelle 3 beziehungsweise während einer halben Periode eines Wechselstroms einen Schwellwert S1, wird dies als Indiz dafür gewertet, dass ein Störlichtbogen brennt. Die Höhe des Stroms ist aber noch nicht allein ein sicheres Zeichen dafür, dass ein Störlichtbogen brennt. Vielmehr muss auch die Rauschleistung P_{N} ausgewertet werden, um ein zusätzliches Indiz für das Vorliegen eines Störlichtbogens zu erhalten.

Unter dem Stromverlauf 1 ist in FIG 1 zeitlich korrespondierend die Rauschleistung P_{N} dargestellt. Erhöhte Rauschleistung ist hier im zeitlichen Fenster der Halbwelle 3 zu beobachten. Bei der Rauschleistung handelt es sich insbesondere um die Rauschleistung hochfrequenter Signale, also um HF-Rauschleistungen. Während eines Zeitabschnitts t₁ liegt die Rauschleistung unterhalb einer Rauschleistungsschwelle S2. Es schließen dann weitere Zeitabschnitte t₃ bis t₈ an, wobei in den Zeitabschnitten t₃ und t₇ kein Störlichtbogen brennt und die Rauschleistung dementsprechend niedrig ist. In den Zeitabschnitten t₄, t₆ und t₈ liegt die Rauschleistung über der Schwelle S2 und in dem Zeitabschnitt t₅ liegt sie wie in dem Zeitabschnitt t₁ unterhalb der Schwelle S2. Die Zeitabschnitte t₃ bis t₆ repräsentieren eine erste Halbperiode des Wechselspannung- beziehungsweise Wechselstromsignals und die Zeitabschnitte t₇ mit t₈ eine zweite Halbperiode. Die Halbwelle 3, während der der Störlichtbogen brennt, erstreckt sich zeitlich jeweils nur über einen Teil der entsprechenden Halbperiode (z. B. t₄ bis t₆ der Halbperiode t₃ bis t₆) .

Der unterste Verlauf in FIG 1 zeigt einen Integratorwert Int1. Der Integratorwert Int1 stellt einen Integrationswert über der Zeit dar. Die Integration wird einfach dadurch implementiert, dass ein Integrator beziehungsweise Zähler in einem fest vorgegebenen Takt beziehungsweise einer fest vorgegebenen Periode hochgezählt wird. Es ergibt sich dann für den Wert Int1 beim Hochzählen ein entsprechender linearer Anstieg wie beispielsweise in dem Zeitabschnitt t2.

Zu Beginn einer Halbwelle 3 steigt hier die Stromstärke so stark an, dass sie den Stromstärkeschwellwert S1 übersteigt. Dies ist für den Integrator prinzipiell das Signal, dass hochgezählt beziehungsweise integriert werden kann. Da allerdings die Rauschleistung P_{N} im ersten Zeitabschnitt t₁ unterhalb des Schwellwerts S2 liegt, wird der Integrator noch nicht hochgezählt. Im Zeitabschnitt t₂ liegt die Rauschleistung dann über dem Schwellwert S2 und der Integrator wird hochgezählt, sodass der Integratorwert Int1 entsprechend linear steigt. Am Ende der Halbwelle 3 endet das Hochzählen mit dem Ende des Zeitabschnitts t₂. Während des Zeitabschnitts t₃ brennt der Störlichtbogen nicht und der Integrator wird dekrementiert. Wie aus der Grafik von FIG 1 zu erkennen ist, wird in dem Beispiel langsamer dekrementiert als inkrementiert. Zu Beginn des Zeitabschnitts t₄ kommt es wieder zu der steilen Flanke 2 und der Integrator wird inkrementiert, da die Rauschleistung in diesem Zeitabschnitt über S2 liegt. In dem Zeitabschnitt t₅ wird dekrementiert, da die Rauschleistung unter der Schwelle S2 liegt. In dem Zeitabschnitt t₆ hingegen wird der Integrator wieder inkrementiert. Entsprechend wird der Integrator in den Zeitabschnitten t₇ und t₈ wieder dekrementiert beziehungsweise inkrementiert.

Während des Zeitabschnitts t₈ übersteigt der Integratorwert Int1 einen Integrationsschwellwert S3. Dieses Überschreiten des Integrationsschwellwerts kann so interpretiert werden, dass sicher einer oder mehrere Störlichtbögen d. h. ein Störlichtbogenereignis, vorhanden waren. Das Überschreiten des Integrationsschwellwerts wird gemäß dem Stand der Technik zum Auslösen eines entsprechenden Schutzschalters herangezogen, der von einer entsprechenden Vorrichtung zum Detektieren eines Störlichtbogenereignisses angesteuert wird beziehungsweise diese beinhaltet.

Entsprechend der vorliegenden Erfindung wird der Auslösemechanismus gemäß FIG 2 weiterentwickelt. Insbesondere soll das Integrationssignal Int1 auch unterhalb des Schwellwerts S3 untersucht werden, sodass bereits vorab erkannt werden kann, ob Materialbeschädigungen durch sehr kurze oder sehr wenige, sporadische Störlichtbögen, bei denen die Schwelle S3 nicht erreicht wird, entstanden sind. In FIG 2 oben ist dazu ein anderer Verlauf des Integrationswerts Int1 dargestellt. Er erreicht den Schwellwert S3 (100 %) nicht. Er übersteigt jedoch zu einem Zeitpunkt t₁₀ einen zweiten Integrationsschwellwert S4. Dieser zweite Integrationsschwellwert S4 beträgt hier 50 % des ersten Integrationsschwellwerts S3. Der zweite Integrationsschwellwert kann aber auch einen anderen Wert besitzen und liegt vorzugsweise in dem Bereich von 30 % bis 70 % des ersten Integrationsschwellwerts S3.

Nach Überschreiten des zweiten Integrationsschwellwerts S4 erlischt beispielsweise der Störlichtbogen und der Integrationswert beziehungsweise der entsprechende Zählerwert wird dekrementiert, sodass der Integrationswert Int1 kontinuierlich auf Null sinkt. Dabei unterschreitet er einen dritten Integrationsschwellwert S5, der hier bei 10 % des ersten Integrationsschwellwerts S3 liegt. Vorzugsweise liegt dieser dritte Integrationsschwellwert S5 unterhalb von 20 % des ersten Integrationsschwellwerts.

Das Absinken des Integrationswerts Int1 unter den dritten Integrationsschwellwert S5 ist typisch für einen sporadischen Störlichtbogen. Daher wird hier die Tatsache genutzt, dass der Integrationswert Int1 zunächst den zweiten Integrationsschwellwert S4 übersteigt und dann zum Zeitpunkt t₁₁ unter den dritten Integrationsschwellwert S5 sinkt.

In der Folge steigt der Integrationswert Int1 wieder über den zweiten Integrationswert S4. Es wird aber durch eine Signalanalyse festgestellt, dass der Anstieg des Integrationswerts von einer Störlast herrührt. Daher wird ein Resetsignal r erzeugt, das in FIG 2 in der Mitte dargestellt ist. Durch das Resetsignal r wird der Integrator zurückgesetzt, und der Integrationsschwellwert Int1 erhält den Wert Null.

Es wird nun ein zweiter Integrator beziehungsweise Zähler eingesetzt, um sporadische Störlichtbogen zu zählen und diese als Störlichtbogenereignis zu detektieren. Sporadische Störlichtbogen zeichnen sich beispielsweise dadurch aus, dass der erste Integrationswert Int1 den zweiten Integrationsschwellwert S4 (50 %) überschreitet und nach Erlöschen des Lichtbogens längere Zeit kein weiterer Lichtbogen auftritt, sodass der Integrationswert Int1 eben unter den dritten Integrationsschwellwert S5 (10 %) sinkt. Um dies zählen zu können, gibt es zwei Möglichkeiten. Zum einen kann der Zähler (Int2) erst dann inkrementiert werden, wenn der erste Integrationswert Int1 den unteren Schwellwert S5 wieder unterschritten hat. Im Beispiel von FIG 2 würde dann das Inkrementieren erst zum Zeitpunkt t₁₁ erfolgen. Gemäß einer zweiten Variante erfolgt das Inkrementieren vorübergehend bereits zum Zeitpunkt des Überschreitens des zweiten Integrationsschwellwerts S4 (50 %), hier zum Zeitpunkt t₁₀. Endgültig bleibt der Zähler beziehungsweise zweite Integrator aber erst zum Zeitpunkt t₁₁ inkrementiert, wenn der erste Integrationswert Int1 unter die 10 %-Schwelle sinkt.

Die Integrationsfunktion Int1 in FIG2 steigt anschließend wieder an und überschreitet zum Zeitpunkt t₁₁ den zweiten Integrationsschwellwert S4. Der Zählerwert beziehungsweise zweite Integrationswert Int2 wird daher vorübergehend wieder inkrementiert. Eine in dem Wechselspannungsnetz durchgeführte Signalanalyse ergibt jedoch, dass die Ursache für den Anstieg des Integrationswerts Int1 eine Störlast ist. Daher wird ein Resetsignal r, hier ein kurzer Impuls, zum Zeitpunkt t₁₃ erzeugt. Wegen des Resetsignals r wird nicht nur der erste Integrationswert Int1 auf Null gesetzt, es wird auch der zweite Integrationswert Int2 um eine Zähleinheit dekrementiert.

Würden mehrere Störlichtbogenereignisse wie zum Zeitpunkt t₁₀ auftreten, so würde der Zähler beziehungsweise zweite Integrator mit jedem derartigen Ereignis inkrementiert werden, und der Integrationswert Int2 würde den Zählerschwellwert S6 überschreiten. Das Überschreiten des Zählerschwellwerts S6 ist dann die Grundlage für das Entscheiden, dass ein Störlichtbogenereignis vorliegt. Mehrere kurze beziehungsweise sporadische Störlichtbögen führen also zu einem kritischen "Störlichtbogenereignis". Mit dem Entscheiden, dass ein Störlichtbogenereignis vorliegt, gilt dieses als detektiert. Eine entsprechende Detektionsinformation kann zum Auslösen eines Schutzschalters verwendet werden.

Nachfolgend wird ein Ausführungsbeispiel in weiteren Einzelheiten erläutert. Basis ist der Erfassungsalgorithmus für Störlichtbögen gemäß der Patentschrift US 5 729 145 A. Der Erfassungsalgorithmus kann sowohl in Hardware als auch in Software realisiert werden. Ein Integrator ändert bei jedem erfassten Störlichtbogen seinen Wert (vergleiche FIG 1). Erreicht der Integrator beziehungsweise der entsprechende Integrationsschwellwert Int1 die Auslöseschwelle (Schwellwert S3), trennt die dafür vorgesehene Einrichtung den Verbraucher vom Netz. Um dieses Schwelle zu erreichen, ist ein stabil brennender Störlichtbogen notwendig. Erkennt der Algorithmus, dass es sich nicht um einen Störlichtbogen, sondern um einen störenden Verbraucher (Störlast) handelt, wird der Integrationswert Int1 auf den Startwert zurückgesetzt (vergleiche FIG 2).

Für die Detektierung von sporadisch auftretenden Lichtbogenfehlern wird nun ein weiterer Integrator beziehungsweise Zähler verwendet. Der Zähler beziehungsweise Integrationswert Int2 wird inkrementiert, wenn der erste Integrationswert Int1 im konkreten Beispiel die 50 %-Schwelle (S4) überschreitet und anschließend unter die 10 %-Schwelle (S5) fällt. Der erste Integrator zur Bildung des ersten Integrationswerts Int1 kann als einfacher Zähler realisiert werden, der in einem fest vorgegebenen Takt hochzählt, was einer zeitlichen Integration entspricht. Die Höhe der Schwellen S4 und S5 und des Inkrements können je nach Bedarf definiert werden.

Der zweite Integrator beziehungsweise Zähler wird dekrementiert, wenn der erste Integrator zurückgesetzt (bei einer Störlast) oder ein festgelegtes Zeitintervall überschritten wird. Das Zeitintervall für das Dekrementieren kann insbesondere vom zweiten Integrationswert Int2 abhängig gemacht werden. Liegt der Integrationswert Int2 beispielsweise über 30 % des vierten Integrationsschwellwerts S6, so erfolgt ein Dekrement beispielsweise nach der Zeit t₃₀. Liegt der Wert Int2 über 50 % von S6, so erfolgt ein Dekrement nach der Zeit t₅₀. Liegt er Wert Int2 über 80 % von S6, so erfolgt ein Dekrement nach der Zeit t₈₀. Für die Zeitintervalle t₃₀, t₅₀ und t₈₀ gilt hier beispielsweise: t₃₀ > t₅₀ > t₈₀.

Die Höhe des Dekrements für das zeitliche Dekrementieren kann anders gewählt werden als die Höhe des Dekrements, wenn der erste Integrationswert Int1 zurückgesetzt wird.

Wird die Auslöseschwelle S6 erreicht oder überschritten, so können mit dieser Information Anzeigemittel oder beispielsweise ein Relais angesteuert werden. Die Erkennung sporadischer Störlichtbögen kann also mit einer Anzeige (z. B. LED) kombiniert werden. Wenn nämlich eine sofortige Abschaltung des Stromnetzes unerwünscht ist, kann dies als Vorwarnmöglichkeit genutzt werden.

Mit der erfindungsgemäßen Detektierung von sporadisch auftretenden Störlichtbögen können Lichtbogenfehler bereits frühzeitig in deren Entstehungsphase erkannt und abgeschaltet werden. Viele Brände, die auf Fehler in der elektrischen Installation zurückzuführen sind, können so vermieden werden. In Sonderfällen, in denen eine sofortige Abschaltung des Stromnetzes nicht erwünscht ist, dies ist vor allem in der Industrie relevant, können optional entsprechende Anzeigemittel oder interne beziehungsweise externe Relais angesteuert werden. Etwaige Wartungsaktionen können dann zu geeigneten Zeitpunkten durchgeführt werden.

### Bezugszeichenliste

- 1: Stromverlauf
- 2: Flanke
- 3: Halbwelle
- Int1: Integrationsfunktion
- Int2: Integrationswert
- r: Resetsignal
- S1: Schwellenwert
- S2: Rauschleistungswelle
- S3 - S5: Integrationsschwellwert
- S6: Zählerschwellwert
- t: Zeit
- t₁ - t₈: Zeitabschnitte
- t₁₀, t₁₁: Zeitpunkt
- t₃₀, t₅₀, t₈₀: Zeitintervalle
- P_{N}: Rauschleistung

## Patentansprüche

1. Verfahren zum Detektieren von Störlichtbogenereignissen in einem Wechselspannungsnetz durch
- Erfassen einer aktuellen Rauschleistung (P_{N}) in dem Wechselspannungsnetz,
- Erfassen einer Amplitude einer Stromstärke (I) in dem Wechselspannungsnetz,
- Erhöhen eines Integrals (Int1) in Abhängigkeit von der Zeit, wenn die aktuelle Amplitude der Stromstärke einen vorbestimmten Stromstärkeschwellwert (S1) überschreitet und die aktuelle Rauschleistung einen Leistungsschwellwert (S2) übersteigt,
- Reduzieren des Integrals (Int1) in Abhängigkeit von der Zeit, wenn die Amplitude den vorbestimmten Stromstärkeschwellwert (S1) nicht überschreitet und/oder die aktuelle Rauschleistung den Leistungsschwellwert (S2) nicht übersteigt, und
- Entscheiden, dass ein Störlichtbogenereignis vorliegt, wenn das Integral (Int1) einen vorgegebenen ersten Integrationsschwellwert (S3) übersteigt,
**gekennzeichnet durch**
- Inkrementieren eines Zählers (Int2) nur dann, wenn das Integral (int1) zunächst einen unter dem ersten Integrationsschwellwert (S3) liegenden zweiten Integrationsschwellwert (S4) überschreitet und anschließend einen unterhalb des zweiten Integrationsschwellwert (S4) liegenden dritten Integrationsschwellwert (S5) unterschreitet, und
- Entscheiden, dass ein anderes Störlichtbogenereignis vorliegt, wenn der Wert des Zählers (Int2) einen vorgegebenen Zählerschwellwert (S6) übersteigt.

2. Verfahren nach Anspruch 1, wobei der zweite Integrationsschwellwert (S4) in einem Bereich zwischen 30 % und 70 % des ersten Integrationsschwellwerts (S3) liegt.

3. Verfahren nach Anspruch 1 oder 2, wobei der dritte Integrationsschwellwert (S5) unter 20 % des ersten Integrationsschwellwerts (S3) liegt.

4. Verfahren nach einem der vorhergehenden Ansprüche, wobei das Erhören und Reduzieren des Integrals (Int1) mit unterschiedlichen Geschwindigkeiten erfolgt.

5. Verfahren nach einem der vorhergehenden Ansprüche, wobei ein Signal in dem Wechselspannungsnetz hinsichtlich einer Störlast analysiert wird, und bei Detektieren einer Störlast das Integral (Int1) auf einen vorgegebenen Wert, insbesondere Null, gesetzt wird.

6. Verfahren nach Anspruch 5, wobei der Zähler (Int2) dekrementiert wird, wenn das Integral (Int1) auf den vorgegebenen Wert gesetzt wird.

7. Verfahren nach einem der vorhergehenden Ansprüche, wobei der Zähler (Int2) nach einem vorgegebenen Zeitintervall dekrementiert wird.

8. Verfahren nach Anspruch 7, wobei das Zeitintervall von dem aktuellen Wert des Zählers (Int2) abhängt.

9. Verfahren zum Betreiben eines Schutzschalters durch Detektieren eines Störlichtbogenereignisses nach einem der vorhergehenden Ansprüche und Auslösen des Schutzschalters oder Ausgeben eines Warnsignals im Falle der Detektion eines Störlichtbogenereignisses.

10. Vorrichtung zum Detektieren von Störlichtbogenereignissen in einem Wechselspannungsnetz mit
- einer Leistungsmesseinrichtung zum Erfassen einer aktuellen Rauschleistung (P_{N}) in dem Wechselspannungsnetz,
- einer Strommesseinrichtung zum Erfassen einer Amplitude einer Stromstärke (I) in dem Wechselspannungsnetz,
- einer Integrationseinrichtung zum Erhöhen eines Integrals (Int1) in Abhängigkeit von der Zeit, wenn die aktuelle Amplitude der Stromstärke einen vorbestimmten Stromstärkeschwellwert (S1) überschreitet und die aktuelle Rauschleistung einen Leistungsschwellwert (S2) übersteigt, sowie zum Reduzieren des Integrals (Int1) in Abhängigkeit von der Zeit, wenn die Amplitude den vorbestimmten Stromstärkeschwellwert (S1) nicht überschreitet und/oder die aktuelle Rauschleistung den Leistungsschwellwert (S2) nicht übersteigt, und
- einer Logikeinrichtung zum Entscheiden, dass ein Störlichtbogenereignis vorliegt, wenn das Integral (Int1) einen vorgegebenen ersten Integrationsschwellwert (S3) übersteigt,
**gekennzeichnet durch**
- eine Zählereinrichtung zum Inkrementieren eines Zählerwerts (Int2) nur dann, wenn das Integral (Int1) zunächst einen unter dem ersten Integrationsschwellwert (S3) liegenden zweiten Integrationsschwellwert (S4) überschreitet und anschließend einen unterhalb des zweiten Integrationsschwellwert (S4) liegenden dritten Integrationsschwellwert (S5) unterschreitet, wobei
- mit der Logikeinrichtung entschieden wird, dass ein anderes Störlichtbogenereignis vorliegt, wenn der Wert des Zählers (Int2) einen vorgegebenen Zählerschwellwert (S6) übersteigt.
